# EUROPEAN PATENT APPLICATION

(11) **EP 1 968 363 A2**
(43) Date of publication of application: **10.09.2008**
(21) Application number: 08151813.6
(22) Date of filing: 22.02.2008
(51) Int. Cl.: H05K 1/16

(54) **Embedded Capacitor**

(30) Priority: 08.03.2007 US 715651
(71) Applicant: Delphi Technologies, Inc., Troy, Michigan 48007 (US)
(72) Inventor: Berlin, Carl W., West Lafayette, IN 47906 (US); Sarma, Dwadasi H.R., Kokomo, IN 46902 (US); Chappell, William J., Lafayette, IN 47905-1455 (US); Hoppenjans, Eric E., Indianapolis, IN 46268 (US)
(74) Representative: Robert, Vincent

(57) **Abstract**

An embedded capacitor method and system is provided for printed circuit boards. The capacitor structure is embedded within an insulator substrate (30B), minimizes real-estate usage, provides a high capacitance, enhances capacitance density, and yet forms an advantageous planar surface topography. A cavity (36) is defined within and contained by an insulator substrate layer (30B), and a dielectric material (38) at least partially fills the cavity (30B). The dielectric material (38) is connected to an electrical conductor (32A, 32B), and vias (34A, 34B) are used for interconnections and traces. In an aspect, a plurality of stacked insulator substrate layers (40B-40F) define a plurality of cavities (41A-41E) filled with the dielectric material (48A-48E), providing even greater capacitance. In another aspect, an array of cavities (76A-76L) is formed in the insulator substrate layer (70). The embedded capacitor can be employed within numerous systems that utilize capacitors including automotive electronics such as a pressure sensor, an engine control module, a transmission controller, and radio systems including satellite radio devices.

## Description

### TECHNICAL FIELD

The invention relates generally to a capacitor structure, and more particularly to an embedded and planar capacitor structure in a multilayer substrate providing a high value capacitance.

### BACKGROUND OF THE INVENTION

The demand for miniaturized electronic devices is ever intensifying with both circuit density and the density of components per unit area significantly increasing. The number of components employed has risen exponentially, necessitating a shrinkage of component size. Since the design of smaller and denser printed circuit boards is approaching a practical limit for today's technology, circuit designers must maximize real-estate usage. In the case of surface mounting, components are added if they are exceptionally small. Alternatively, components can be added if they are buried within inner layers, as in the case of vertical stacking.

Passive circuit components embedded in printed circuit boards (PCB) and thick film resistor and dielectric compositions are presently used. The practice of embedding capacitors in printed circuit boards allows for reduced circuit size and improved circuit performance. Typically, a viscous thick film composition is screen-printed in a desired design, and then fired at a temperature to bum out organic components and sinter the inorganics. The result is a thick film component embedded into the circuitry. Capacitors are also embedded in layers that are stacked and connected by interconnection circuitry, the stack of layers forming a printed circuit board. The thick-film capacitor material may include high dielectric constant materials, glasses and/or dopants, and should have a high dielectric constant (K) after firing.

Embedding capacitors, however, are characteristically limited to low capacitance values due to design and manufacturing constraints. One contemporary process utilizes LTCC tape as a capacitor dielectric. An upper and a lower conductive material are deposited on a LTCC tape layer. A number of LTCC tape and conductors are then stacked and fired, forming a passive electronic component. This process presents a limitation in that it is only useful for low value capacitors in the range of about 0.01 to 0.1 nanofarads (nF). Further, an excessively large area of real estate is required to provide even a low value capacitance.

Another contemporary process utilizes a high K thick film dielectric in creating an embedded capacitor structure. The thick film electrodes and the capacitor dielectric are situated between, for example, LTCC layers. However, when the device is fired, an undesirable surface topography results. A non-planar bump results, which presents its own limitations and problems.

Currently, known embedded capacitance materials are fabricated with a dielectric thickness of about 0.5 to 1.0 mils and a capacitance density of about 5 to 200 nF per square inch. Therefore, an embedded, planar, high capacitance and high density structure that occupies limited space is needed for printed circuit boards.

### SUMMARY OF THE INVENTION

An embedded capacitor method and system is provided for printed circuit boards. The capacitor structure is embedded in a substrate, provides a high capacitance, and yet forms an advantageous planar surface topography. The embedded capacitor minimizes real-estate usage by occupying limited space and enhancing capacitance density in a printed circuit board. This in turn results in an overall reduced circuit size and improved circuit performance. The capacitor structure may also be embedded in a multilayer substrate providing even greater capacitance, and yet the capacitor structure maintains a planar surface topography.

The present invention embedded capacitor can be employed within electronic systems that utilize capacitors, and can be especially useful to those systems requiring miniaturized component electronics. Some systems that benefit from the present invention include automotive electronics such as a pressure sensor, an engine control module, a transmission controller, as well as radio systems including satellite radio devices.

Costs are contained and reduced, in part, by the present invention by utilizing readily available materials. As an example, the insulator substrate layer can utilize low temperature co-fired ceramic (LTCC), high temperature co-fired ceramic (HTCC), or Flame Resistant 4 (FR-4). Readily available dielectric fill material may also be employed including a thick film paste.

Features of the invention are achieved in part by embedding a capacitor structure in an insulator substrate layer. A cavity is defined within and contained by the insulator substrate layer, and a dielectric fill material at least partially fills the cavity. In an embodiment, the percentage of the insulator substrate layer defining the cavity that is filled with the dielectric fill material is in the range of 25 percent to 35 percent. An electrical conductor contacts the dielectric fill material, and in embodiment, further contacts the insulator substrate layer for a varied effective capacitance. A via, commonly defined by an insulator substrate layer for interconnections and traces, includes the electrical conductor extending therethrough.

In an embodiment, the embedded capacitor is formed in a stacked and interconnected structure. A plurality of the insulator substrate layers (a multilayer substrate) defines a plurality of cavities filled with the dielectric fill material. The plurality of cavities filled with the dielectric material are connected in parallel via the electrical conductor. In an embodiment, the multilayer substrate defining the plurality of cavities filled with the dielectric fill material are formed between an upper insulator substrate layer and a lower insulator substrate layer.

In a further embodiment, an array of cavities is formed in the insulator substrate layer. The array of cavities can yet be further formed in a multilayer of substrates. The cavities can additionally be filled having various dielectric fill materials. For example, a first group of cavities may contain a dielectric fill material having a first dielectric constant, and a second group of cavities may contain the dielectric fill material having a second dielectric constant.

Other features and advantages of this invention will be apparent to a person of skill in the art who studies the invention disclosure. Therefore, the scope of the invention will be better understood by reference to an example of an embodiment, given with respect to the following figures.

### BRIEF DESCRIPTION OF THE DRAWINGS

The foregoing aspects and many of the attendant advantages of this invention will become more readily appreciated by reference to the following detailed description, when taken in conjunction with the accompanying drawings, wherein:
FIG. 1 is a perspective view of a prior art capacitor that utilizes LTCC tape as a capacitor dielectric material;
FIG. 2 illustrates a perspective view of another prior art single layer capacitor that embeds a double print thick film capacitor dielectric and thick film electrodes between LTCC tape layers;
FIG. 3 is a sectional side view illustrating a cavity defined within a substrate, having a dielectric fill material connected to a conductor and interconnected through vias, and forming a capacitor structure, in accordance with an embodiment of the present invention;
FIG. 4 is a sectional side view illustrating the fabrication of a multilayer substrate defining cavities and forming a capacitor structure, in accordance with an embodiment of the present invention;
FIG. 5 is a cross-sectional view illustrating a multilayer substrate with a defined cavity with dielectric fill material, having a conductor plate interconnected through a via and forming a capacitor structure, in accordance with an embodiment of the present invention;
FIG. 6 illustrates a plan view of a section of the structure of FIG. 5, wherein the connection of the dielectric fill material, the conductor plate, and the interconnecting via is further illustrated, in accordance with an embodiment of the present invention;
FIG. 7 is a perspective view of an array of cavities defined within a substrate with dielectric fill material and connected by a conductor plate and interconnecting vias, forming a capacitor structure in accordance with an embodiment of the present invention;
FIG. 8 is a perspective view of an array of cavities defined within a multilayer substrate with dielectric fill material and connected by a conductor plate and interconnecting vias, forming a capacitor structure in accordance with an embodiment of the present invention;
FIG. 9 is another perspective view of a cavity defined within a multilayer substrate as in FIG. 5, further illustrating a printed circuit board having vias and additional interconnects, and forming a capacitor structure in accordance with an embodiment of the present invention;
FIG. 10 is graphical illustration of the percentage of the substrate layer defining the cavity that is filled with the dielectric fill material versus the effective dielectric constant, for various values of dielectric fill materials, in accordance with an embodiment of the present invention; and
FIG. 11 is graphical illustration of the percentage of the substrate layer defining the cavity that is filled with the dielectric fill material versus the capacitance density for cavities defined within a multilayer substrate, in accordance with an embodiment of the present invention.

### DESCRIPTION OF THE PREFERRED EMBODIMENTS

Exemplary embodiments are described with reference to specific configurations. Those of ordinary skill in the art will appreciate that various changes and modifications can be made while remaining within the scope of the appended claims. Additionally, well-known elements, devices, components, methods, process steps and the like may not be set forth in detail in order to avoid obscuring the invention. Further, unless indicated to the contrary, the numerical values set forth in the following specification and claims are approximations that may vary depending upon the desired characteristics sought to be obtained by the present invention.

A system and method are described herein for providing an embedded capacitor for printed circuit boards. The capacitor structure is embedded in an insulator substrate, provides a high capacitance, and yet forms an advantageous planar surface topography. The embedded capacitor minimizes real-estate usage and enhances capacitance density in a printed circuit board. This in turn results in an overall reduced circuit size and improved circuit performance.

The present invention embedded capacitor can be employed within numerous electronic systems that utilize capacitors, and can be especially useful to those systems requiring miniaturized component electronics and high capacitance. Some systems that benefit from the present invention include automotive electronics such as a pressure sensor, an engine control module, a transmission controller, as well as radio systems including satellite radio devices.

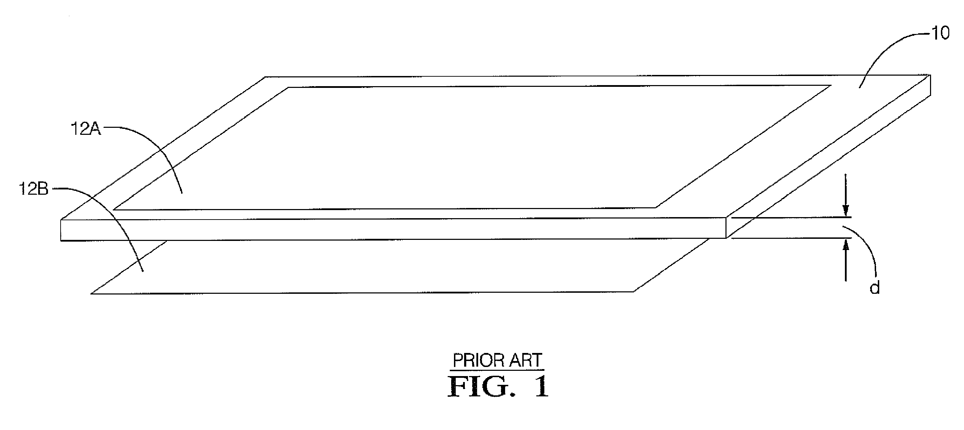

Referring to the drawings wherein identical reference numerals denote the same elements throughout the various views, **FIG. 1** illustrates a perspective view of a prior art capacitor that utilizes LTCC tape as the capacitor dielectric material. As shown, the dielectric material 10 is positioned between two conductor plates 12A and 12B. Typically, the dielectric material 10 is a Low Temperature Cofired Ceramic (LTCC) tape. The capacitance depends on the dielectric constant K for the dielectric material 10, the area of the conductor plates 12A and 12, the diameter (d) of the dielectric material 10, as well as the permittivity of a vacuum (∈₀). The dielectric constant is the ratio between the absolute permittivity of a material and the absolute permittivity of vacuum. In practice, this contemporary capacitor is limited in usefulness to low value capacitors, since excessively large areas are required to achieve a higher capacitance. Further, the LTCC tape provides a limited dielectric constant K, limiting the capacitance available. An LTCC tape typically has a dielectric constant of only about 7.5.

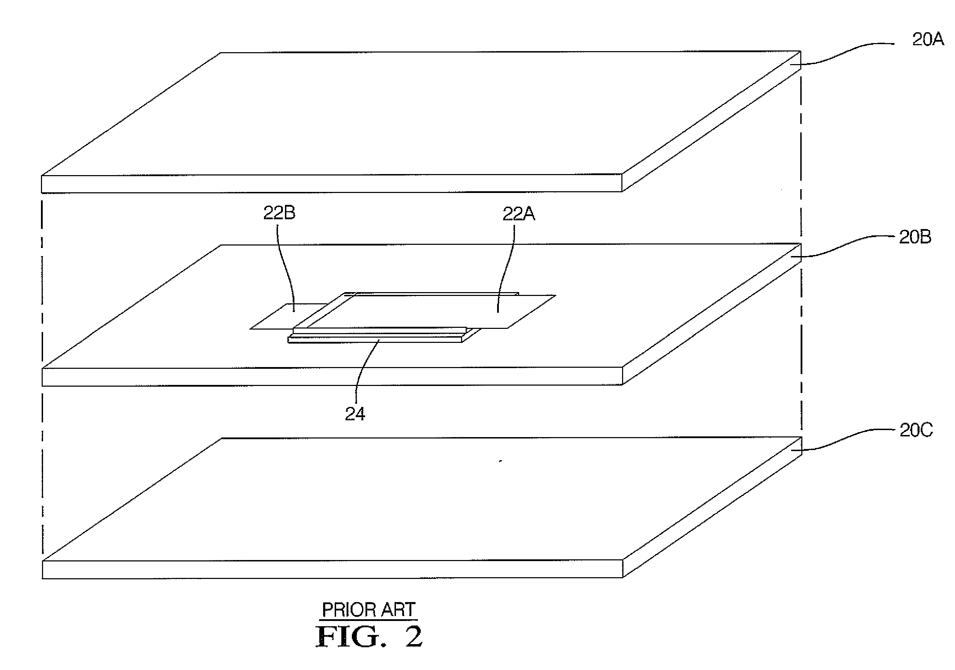

**FIG. 2** illustrates a perspective view of another prior art single layer capacitor that embeds a double print thick film capacitor dielectric and thick film electrodes between LTCC tape layers. A high K thick film dielectric paste 24 is screen printed on LTCC tape 20B and then laminated between LTCC layers 20A and 20C with electrodes 22A and 22B, as well as with interconnected circuitry. This contemporary design is effectively limited to single layer capacitors in practice. An undesirable surface topography results with this conventional design in that a bump is formed with the stack up, which becomes even larger with more stacked materials.

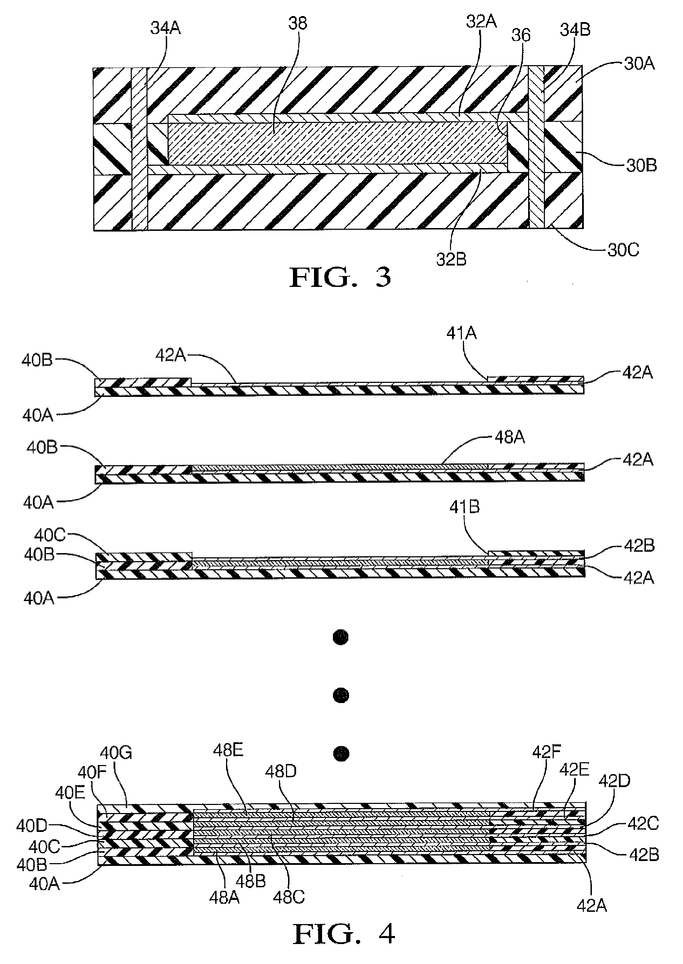

**FIG. 3** is a sectional side view illustrating a cavity 36 defined within a substrate layer 30B, having a dielectric fill material 38 connected to conductors 32A and 32B and interconnected through vias 34A and 34B, and forming a capacitor structure, in accordance with an embodiment of the present invention. Vias 34A and 34B are utilized as electrically conductive interconnects for the conductors 32A and 32B. The insulator substrate layers 30A, 30B and 30C may also have conductor traces and electrical interconnects for other components, passing through the available vias 34A and 34B. As compared to the prior art designs previously described, the present invention integrates the dielectric fill material 38 into a cavity formed in an intermediate position within, and contained by, the insulator substrate layer, for example, insulator substrate layer 30B. As illustrated, via 34A passes an interconnect conductor that makes an electrical connection to conductor 32B. Similarly, via 34B passes an interconnect conductor that makes an electrical connection to conductor 32A. The capacitance is formed across the cavity 36 and the dielectric material 38. In another embodiment, the insulator substrate layer 30B is further utilized for the dielectric constant. That is, the dielectric fill material 38 and the insulator substrate layer 30B may both be utilized to affect the effective capacitance of the embedded capacitor structure. Further, the insulator substrate layer 30B can be designed to possess a dielectric constant having different value as compared with the dielectric fill material 38.

A printed circuit board (PCB) requires insulation to avoid a short circuit, must be physically strong to protect i.e., copper tracks placed upon it, and have other described physical and electrical qualities. The insulator substrate layers 30A, 30B and 30C can be prepared of a low temperature co-fired ceramic (LTCC), a high temperature co-fired ceramic (HTCC), Flame Resistant 4 (FR-4), or the like. LTCC provides cost efficiency for high volumes, high packaging density, reliability, dielectric thickness control, and high print resolution of conductors. LTCC is made from multilayer ceramic dielectric tape and conductor materials such as silver or gold are screen printed on the green ceramic tape. FR-4 is another material used for producing a PCB. FR-4 is manufactured as an insulator without copper cladding and is typically a difunctional resin with a greenish color. FR-4 has low loss at high frequencies, absorbs less moisture, has greater strength and stiffness and is highly flame resistant compared to other mateials. FR-4 is widely used to build high-end consumer, industrial, and military electronic equipment. G-10 is another material used for producing a PCB, but G-10 lacks FR-4's self extinguishing flammability characteristics, and FR-4 has widely replaced G-10 in most applications.

In an embodiment, the cavity 36 is formed with a diameter greater than 90 mils, and in particular embodiments in the range of 90 mils to 100 mils. A mil is defined herein is a unit of length of 0.001 of an inch. Further, in an embodiment, the percentage of the insulator substrate layer 30B defining the cavity that is filled with the dielectric fill material is in the range of 25 percent to 35 percent. Other percentages can also be used depending on the capacitance desired. Costs may be further reduced by utilizing readily available dielectric fill material including a thick film paste such as K60, K500 and K1800, by the DuPont Corporation ^{™}.

Referring to **FIG. 4****,** a sectional side view is illustrated of the fabrication of a multilayer substrate defining cavities and forming a capacitor structure, in accordance with an embodiment of the present invention. A "stack-up" process is employed by the present invention starting with a first layer of insulator substrate 40A (i.e., solid LTCC green tape). The bottom electrode 42A is printed on top of the first layer of insulator substrate 40A. A second insulator substrate 40B, having a defined cavity 41A is then tacked on top of the first insulator substrate layer 40A. A dielectric fill material 48A (such as a high-K paste) is then screen printed into the cavity 41A and dried. The dielectric fill material 48A can either partially fill or completely fill cavity 41A, depending on the desired capacitance. Once the dielectric fill material 48A is dried, another electrode 42B is printed on top of the dry dielectric fill material 48A. The electrodes 42A and 42B electrically connected with the dielectric fill material 48A. Following the second electrode 42B print, another layer of insulator substrate 40C containing a cavity is tacked onto the stack creating another cavity 41B in the insulator substrate stack. Dielectric fill material is then screened into the cavity 41B and the process is repeated until the number of desired capacitor layers is reached. This is illustrated by insulator substrate layers 40A -40G, electrodes 42A - 42F, and dielectric fill material 48A - 48E, which may be designed with greater or less stacks.

Cavities 48A and 48B can be formed in various shapes and sizes, utilizing die cutouts or alternatively utilizing other layering techniques of the insulator substrate layer. Laser trimming of the capacitance may also be employed by using a laser to cut the LTCC thick film or filled cavity at the current path. The cut reduces the effective width of the LTCC thick film or the cavity having the dielectric fill material, thereby changing the effective capacitance to a desired value.

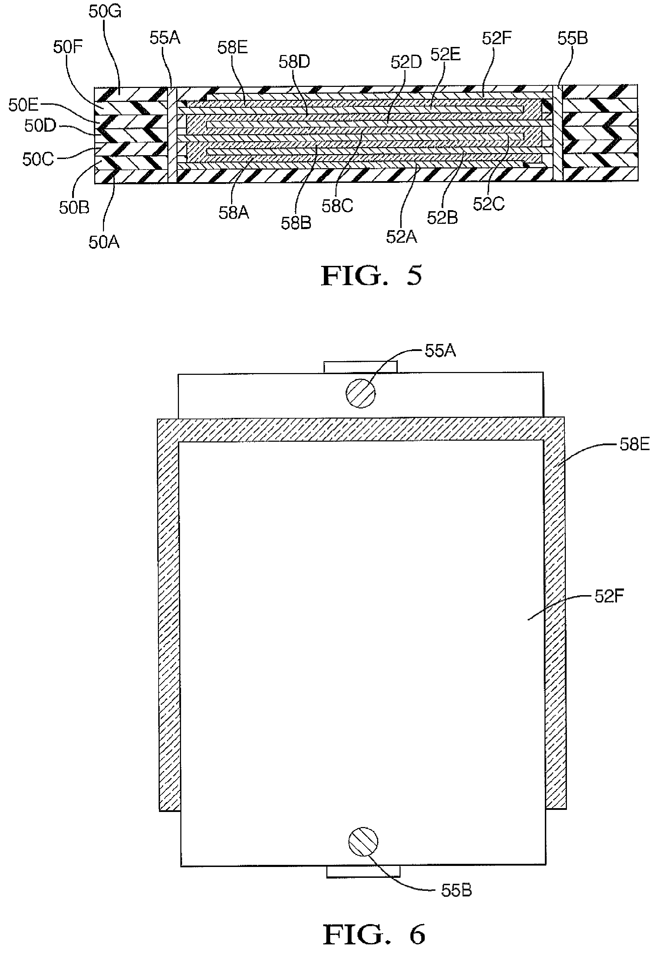

**FIG. 5** is a cross-sectional view illustrating a multilayer insulator substrate with a defined cavity having a dielectric fill material forming a capacitor structure, in accordance with an embodiment of the present invention. The multilayer insulator layers 50B - 50F define cavities with fill material 58A - 58E. In an embodiment, the fill material 58A - 58E are connected in parallel, by way of the conductor plates 52A - 52F. The conductor plates 52A - 52F are also interconnected through vias 55A and 55B, vias 55A and 55B being customarily defined through the insulator substrate layers. By embedding the present invention capacitor structure in a multilayer substrate and interconnecting the fill material 58A - 58E as shown, the capacitance is added, providing an even greater capacitance. Nevertheless, the capacitor structure maintains a desirable planar surface topography.

The capacitance is formed across the cavities and the dielectric fill materials 58A - 58E. In another embodiment, the insulator substrate layers 50B - 50F are further utilized for their dielectric constant. That is, the dielectric fill material 58A - 58E and the insulator substrate layers 50B - 50F may both be utilized to affect the effective capacitance of the embedded capacitor structure. Additionally, in an embodiment, an upper insulator substrate layer 50G and a lower insulator substrate layer 50A, are formed above and below the insulator substrate layers 50B - 50F defining the plurality of cavities filled with the dielectric fill material 58A - 58E.

A plan view is illustrated in **FIG. 6** of a section of the structure of FIG. 5, wherein the connection of the dielectric fill material 58E, the conductor plate 52F, and the interconnecting vias 55A and 55B are further illustrated, in accordance with an embodiment of the present invention. The upper insulator substrate layer 50G and the outer perimeter of the insulator substrate layers 50A - 50F are absent from this illustration for viewing purposes.

In an embodiment, the percentage of the insulator substrate layers 50B - 50F (FIG. 5) defining the cavity that is filled with the dielectric fill material is in the range of 25 percent to 35 percent. Other percentages can also be used depending on the capacitance desired. Additionally, the cavities formed in the insulator substrate layers 50B - 50F are filled with a predetermined volume of the dielectric fill material.

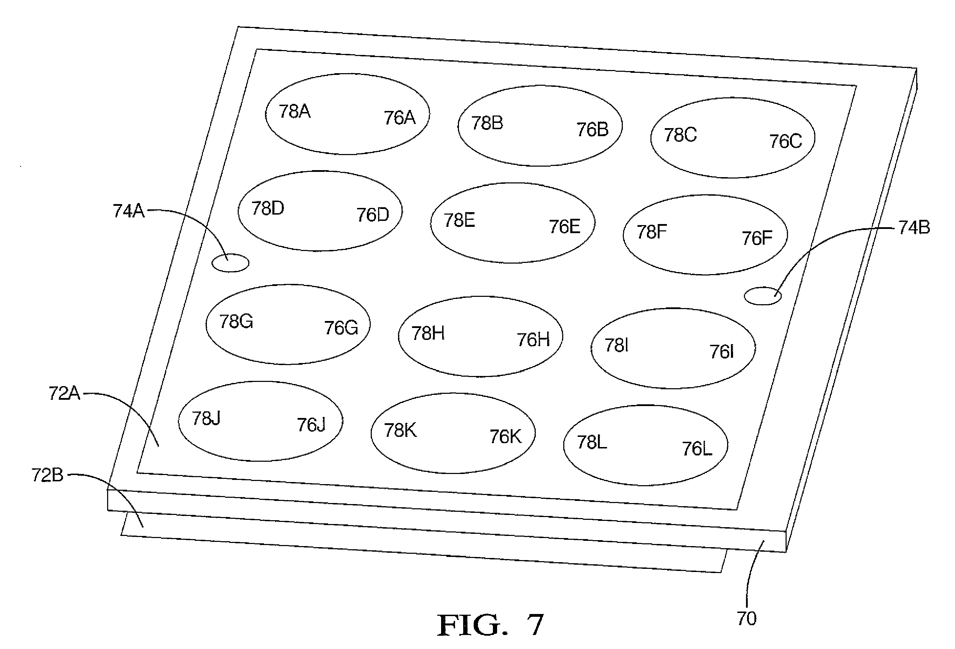

Referring to **FIG. 7****,** a perspective view is illustrated of an array of cavities 76A - 76L defined within a substrate 70, having a dielectric fill material 78A - 78L connected to a conductor 72A and 72B and interconnected through vias 74A and 74B, and forming a capacitor structure, in accordance with an embodiment of the present invention.

Vias 74A and 74B are utilized as electrically conductive interconnects for the conductors 72A and 72B. In an example, via 74A passes an interconnect conductor that makes an electrical connection to conductor 72A, while via 74B passes an interconnect conductor that makes an electrical connection to conductor 72B. The capacitance is formed across the cavities 76A -76L and the dielectric material 78A - 78L. In another embodiment, the insulator substrate layer 70 is further utilized for the dielectric constant. That is, the dielectric fill material 78A - 78L and the insulator substrate layer 70 may both be utilized to affect the effective capacitance of the embedded capacitor structure.

In an embodiment, the percentage of the insulator substrate layer 70 defining the array of cavities that is filled with the dielectric fill material is in the range of 25 percent to 35 percent. Other percentages can also be used depending on the capacitance desired.

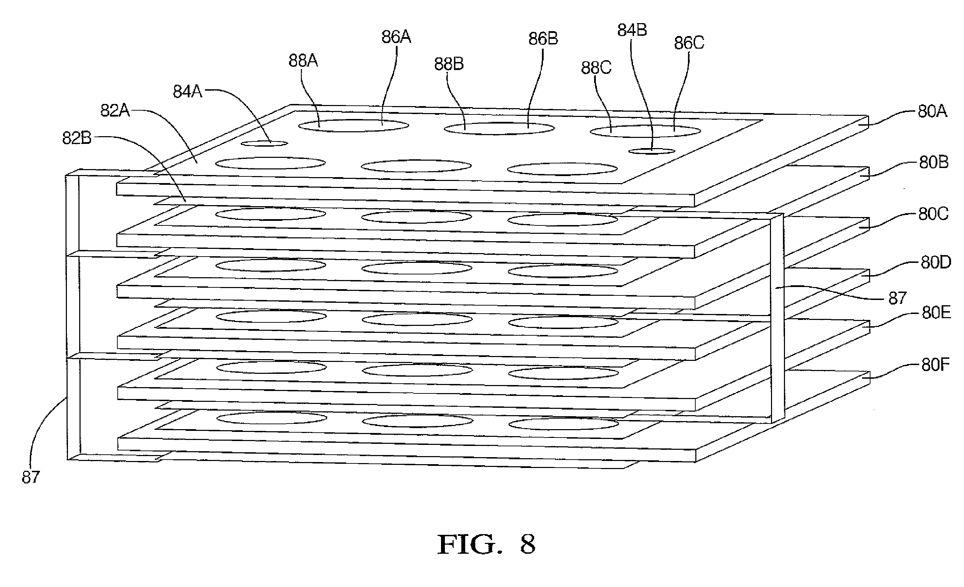

**FIG. 8** is a perspective view of an array of cavities (88A, 88B, 88C and the like) defined within a multilayer substrate (80A - 80F) with dielectric fill material (86A, 86B, 86C, and the like) and connected by conductor plates (82A, 82B and the like) and interconnecting vias (84A, 84B), forming a capacitor structure in accordance with an embodiment of the present invention. In an embodiment, the dielectric fill material (86A, 86B, 86C, and the like) are connected in parallel by way of the conductor plates (82A, 82B and the like), the conductor interconnects 87, and the vias (84A and 84B). The conductor interconnects 87 pass through the vias (84A and 84B), but for clarity the conductor interconnects 87 are shown outside the vias. By interconnecting the dielectric fill material (86A, 86B, 86C, and the like) in parallel, the capacitance is added, providing an even greater capacitance. Nevertheless, the capacitor structure maintains a desirable planar surface topography.

The capacitance is formed across the cavities (88A, 88B, 88C, and the like) and the dielectric fill material (86A, 86B, 86C, and the like). In another embodiment, the insulator substrate layer (80A - 80F) is further utilized for the dielectric constant. Further, in an embodiment, the percentage of the insulator substrate layers (80A - 80F) defining the array of cavities that is filled with the dielectric fill material is in the range of 25 percent to 35 percent. Other percentages can also be used depending on the capacitance desired.

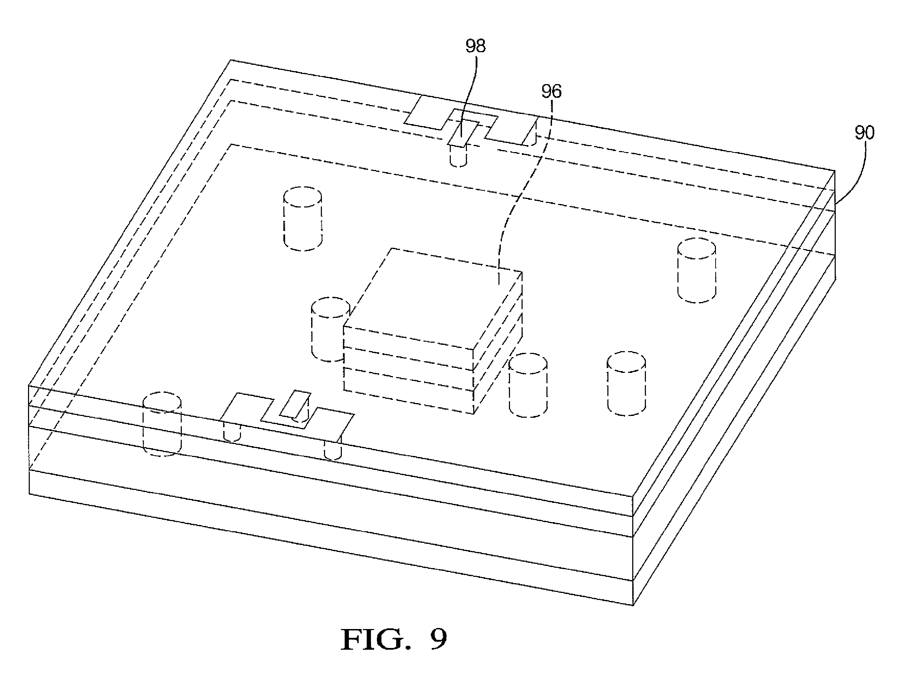

**FIG. 9** illustrates another perspective view of a cavity with dielectric fill material 96 defined within a multilayer substrate 90 as in FIG. 5, further illustrating a printed circuit board having vias 94 and additional interconnects 98, and forming a capacitor structure in accordance with an embodiment of the present invention. It is to be appreciated that the cavity with dielectric fill material 96 can be positioned as needed in the printed circuit board. The cavity can be shaped and sized as need in the printed circuit board as well.

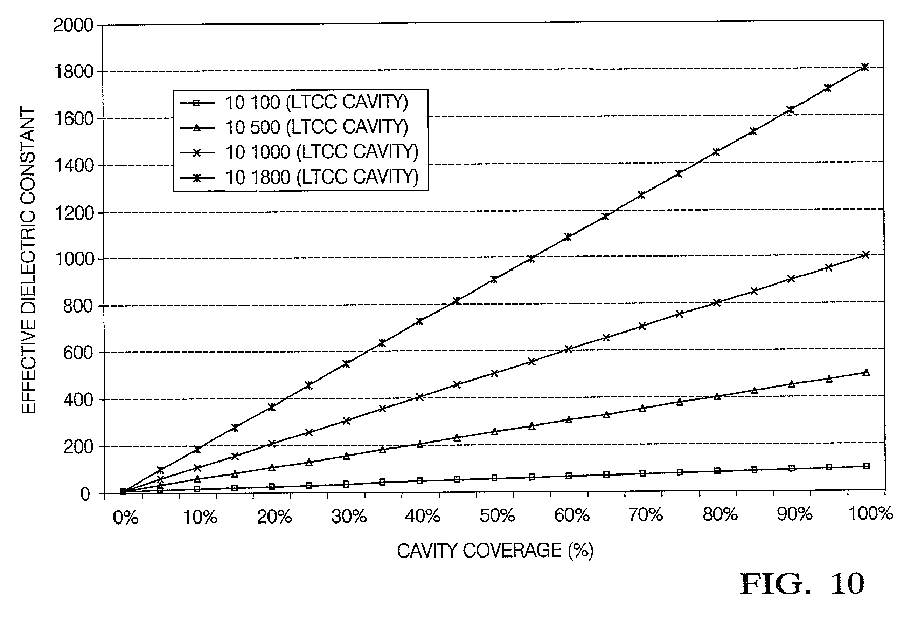

A further understanding of the above description can be obtained by reference to the following experimental result examples that are provided for illustrative purposes and are not intended to be limiting. A graphical illustration is presented in **FIG. 10** of the percentage of the substrate layer defining the cavity that is filled with the dielectric fill material versus the effective dielectric constant, for various values of dielectric fill materials, in accordance with an embodiment of the present invention. The descriptive key section shows four plots lines representing four described experiment conditions. All experiments utilized an insulator substrate layer (an LTCC layer) with a dielectric constant of 10. The dielectric fill material in the cavity was varied, with dielectric constants of 100, 500, 1000, and 1800. As shown, the effective dielectric constant of the embedded capacitor structure increases with the percentage of the substrate layer defining a cavity that is filled with the dielectric fill material. Additionally, a greater effective dielectric constant results when the dielectric fill material with a greater dielectric constant is used.

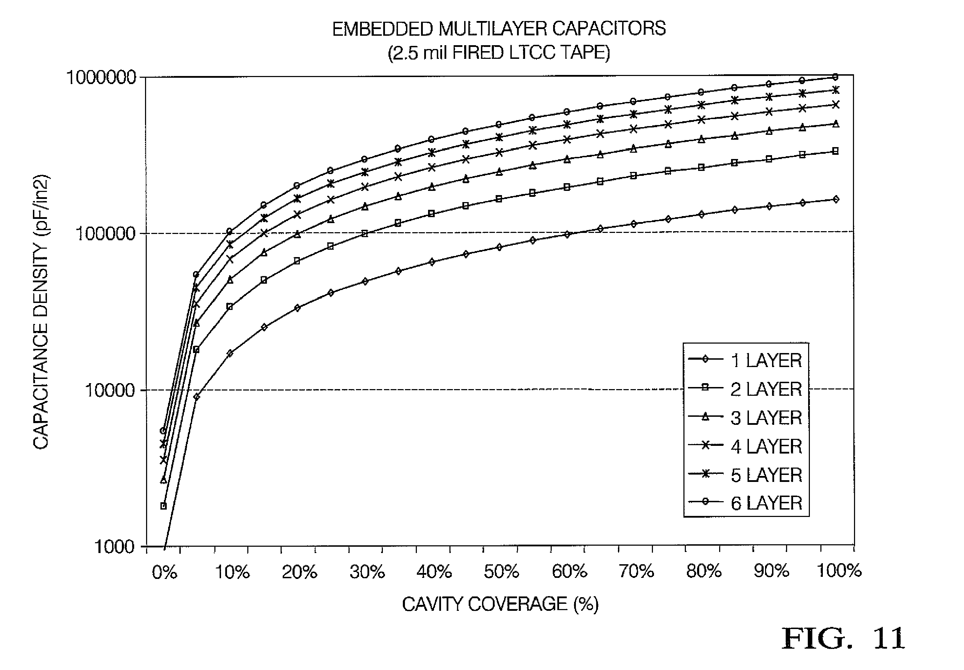

A graphical illustration is presented in **FIG. 11** of the percentage of the substrate layer defining the cavity that is filled with the dielectric fill material versus the capacitance density for cavities defined within a multilayer substrate, in accordance with an embodiment of the present invention. All experiments utilized an insulator substrate layer (an LTCC layer) with a dielectric constant of 10, and a dielectric fill material situated in the cavity with a dielectric constant of 1000. Further, the descriptive key section shows six plots lines representing six described experiment conditions, wherein the embedded capacitor structure was formed in 1 layer, and multilayer up to 6 layers. As shown, the capacitance density of the embedded capacitor structure increases with the percentage of the substrate layer defining a cavity that is filled with the dielectric fill material. Additionally, employing a greater number of multilayer substrates having cavities filled with dielectric fill material results in a greater capacitance density.

Other features and advantages of this invention will be apparent to a person of skill in the art who studies this disclosure. Thus, exemplary embodiments, modifications and variations may be made to the disclosed embodiments while remaining within the spirit and scope of the invention as defined by the appended claims.

## Claims

1. An embedded capacitor structure in an insulator substrate layer (30B) comprising:
a cavity (36) defined by the insulator substrate layer (30B), wherein the cavity (36) is formed in an intermediate position within, and contained by, the insulator substrate layer (30B);
a dielectric fill material (38) at least partially filling the cavity (36); and
an electrical conductor (32A, 32B) having a first electrode (32A) in contact with the dielectric fill material (38) at a first portion of the cavity (36), and having a second electrode (32B) in contact with the dielectric fill material (38) at a second portion of the cavity (36).

2. The embedded capacitor structure as in claim 1, further comprising a via (34A, 34B) defined by the insulator substrate layer (30B), wherein a portion of the electrical conductor (32A, 32B) extends through the via (34A, 34B).

3. The embedded capacitor structure as in claim 1, wherein the electrical conductor (32A, 32B) at least one of the first electrode (32A) and the second electrode (32B) further contacts the insulator substrate layer (30B), and wherein the insulator substrate layer (30B) has a dielectric constant with a first value and the dielectric fill material (38) has a dielectric constant with a second value.

4. The embedded capacitor structure as in claim 1, further comprising a plurality of the insulator substrate layer (40B-40F) defining a plurality of the cavity (41A-41E), making up a plurality of cavities, at least partially filled with the dielectric fill material (48A-48E), wherein the plurality of cavities (41A-41E) filled with the dielectric fill material (48A-48E) are connected in parallel by way of the electrical conductor (42A-42F).

5. The embedded capacitor structure as in claim 1, wherein the dielectric fill material (58A-58E) further includes a first intermediate electrode (52C) and a second intermediate electrode (52D) with a portion of the dielectric fill material (58C) situated therebetween, wherein the first intermediate electrode (52C) and the second intermediate electrode (52D) are positioned between the first electrode (52A) and the second electrode (52F).

6. The embedded capacitor structure as in claim 1, wherein the insulator substrate layer (30B) is formed from a plurality of sheets.

7. The embedded capacitor structure as in claim 1, wherein the percentage of the insulator substrate layer (30B) defining the cavity (36) that is filled with the dielectric fill material (38) is in the range of 25 percent to 35 percent.

8. The embedded capacitor structure as in claim 1, wherein the cavity (36) has a diameter greater than 90 mils.

9. The embedded capacitor structure as in claim 1, wherein the insulator substrate layer (30B) is one of low temperature co-fired ceramic (LTCC), high temperature co-fired ceramic (HTCC), and Flame Resistant 4 (FR-4), and wherein the dielectric fill material (38) is a thick film paste.

10. The embedded capacitor structure as in claim 1, wherein the cavity (30B) comprises an array of cavities (76A-76L) defined by the insulator substrate layer (70).

11. The embedded capacitor structure as in claim 10, further comprising a plurality of the insulator substrate layer (80A-80F) defining a plurality of the array of cavities (86), wherein the plurality of the array of cavities (86) filled with the dielectric fill material are connected in parallel by way of the electrical conductor (87).

12. The embedded capacitor structure as in claim 10, wherein the array of cavities (76A-76L) comprises a first group of cavities (76A-76F) and a second group of cavities (76G-76L), wherein the first group of cavities (76A-76F) contain the dielectric fill material having a first dielectric constant, and the second group of cavities (76G-76L) contain the dielectric fill material having a second dielectric constant.

13. A method of embedding a capacitor structure in an insulator substrate layer (30B) comprising:
defining a cavity (36) by the insulator substrate layer (30B), wherein the cavity (36) is formed in an intermediate position within, and contained by, the insulator substrate layer (30B);
at least partially filling the cavity (36) with a dielectric fill material (38); and
electrically connecting an electrical conductor (32A, 32B) with the dielectric fill material (38), wherein the electrical conductor (32A, 32B) includes a first electrode (32A) and a second electrode (32B), the first electrode (32A) in contact with the dielectric fill material (38) at a first portion of the cavity (36), and the second electrode (32B) in contact with the dielectric fill material (38) at a second portion of the cavity (36).

14. The method as in claim 13, further comprising defining a via (34A, 34B) through the insulator substrate layer (30B), and extending a portion of the electrical conductor (32A, 32B) through the via (34A, 34B).

15. The method as in claim 13, further comprising forming the insulator substrate layer (30B) with a first dielectric constant, forming the dielectric fill material (38) with a second dielectric constant, and electrically contacting the insulator substrate layer (30B) with at least one of the first electrode (32A) and the second electrode (32B).

16. The method as in claim 13, further comprising establishing a plurality of the insulator substrate layer (40B-40F) to define a plurality of the cavity (41A-41E) at least partially filled with the dielectric fill material (48A-48E), and connecting the plurality of cavities (41A-41E) in parallel, by way of the electrical conductor (42A-42F).

17. The method as in claim 13, further comprising forming a first intermediate electrode (52C) and a second intermediate electrode (52D) within the dielectric fill material (58A-58E) with a portion of the dielectric fill material (58C) situated therebetween, wherein the first intermediate electrode (52C) and the second intermediate electrode (52D) are positioned between the first electrode (52A) and the second electrode (52F).

18. The method as in claim 13, further comprising filling 25 percent to 35 percent of the insulator substrate layer (30B) with the dielectric fill material (38).

19. The method as in claim 13, wherein defining the cavity (30B) comprises defining an array of cavities (76A-76L) by the insulator substrate layer (70).

20. The method as in claim 19, wherein the insulator substrate layer (30B) comprises a plurality of the insulator substrate layer (80A-80F) defining a plurality of the array of cavities (86), and wherein the plurality of the array of cavities (86) filled with the dielectric fill material are connected in parallel by way of the electrical conductor (87).
